(19)

Europäisches Patentamt
European Patent Office
Office européen des brevets

(11) **EP 4 346 098 A1**

(12) **EUROPEAN PATENT APPLICATION**

(43) Date of publication:
**03.04.2024 Bulletin 2024/14**

(21) Application number: **22306454.4**

(22) Date of filing: **30.09.2022**

(51) International Patent Classification (IPC):
**H03F 1/02** (2006.01)      **H03F 1/32** (2006.01)
**H03F 1/56** (2006.01)      **H03F 3/195** (2006.01)

(52) Cooperative Patent Classification (CPC):
**H03F 1/0288; H03F 1/3288; H03F 1/565;**
**H03F 3/195;** H03F 2200/241; H03F 2200/243;
H03F 2200/451

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**
Designated Extension States:
**BA ME**
Designated Validation States:
**KH MA MD TN**

(71) Applicant: **NXP USA, Inc.**
**Austin TX 78735 (US)**

(72) Inventors:
• **Cavarroc, Manuel**
**31023 Toulouse (FR)**

• **Lembeye, Olivier**
**31023 Toulouse (FR)**
• **Lamy, Anthony**
**31023 Toulouse (FR)**

(74) Representative: **Miles, John Richard**
**NXP SEMICONDUCTORS**
**Intellectual Property Group**
**Abbey House**
**25 Clarendon Road**
**Redhill, Surrey RH1 1QZ (GB)**

(54) **AMPLIFIER DEVICE WITH PHASE SLOPE ADJUSTMENT CIRCUITRY**

(57)      An amplifier device (600) having multiple amplification paths, such as a Doherty amplifier device, may include phase slope adjustment circuitry (606) configured to adjust the frequency-dependent slope of the phase of an input carrier signal along a carrier path of the amplifier (600). By adjusting the phase slope of the input carrier signal in this way, the phase difference between carrier and peaking signals at an output combining node of the amplifier (600) may be reduced, thereby reducing output power ripple of the amplifier (600). The phase slope adjustment circuitry (606) may be a constant-k bandpass filter. The phase slope adjustment circuitry (606) may have a zero-degree insertion phase at the center frequency of the amplifier (600). The phase slope adjustment circuitry (606) may be implemented using surface mount inductors and capacitors.

FIG. 6

EP 4 346 098 A1

## Description

TECHNICAL FIELD

Embodiments of the subject matter described herein relate generally to radio frequency (RF) amplifier devices and more specifically to RF amplifiers having phase slope adjustment circuitry.

BACKGROUND

Radio frequency (RF) amplifiers are typically used to receive RF signals, amplify the RF signals, and provide the amplified RF signals at an output. In the case of Doherty amplifiers, the full power bandwidth of a given amplifier is dependent on the frequency deviation between the input paths thereof, whereas the low power bandwidth is not dependent on such frequency deviation. At full power, differences between input path and output path frequency deviation in such RF amplifiers results in a phase misalignment between the main current and the peaking current at the combining node. This results in a trade-off between the low power bandwidth and the full power bandwidth of such amplifiers, which limits wideband RF performance.

SUMMARY

A brief summary of various exemplary embodiments is presented below. Some simplifications and omissions may be made in the following summary, which is intended to highlight and introduce some aspects of the various exemplary embodiments, without limiting the scope. Detailed descriptions of an exemplary embodiment adequate to allow those of ordinary skill in the art to make and use these concepts will follow in later sections.

In an example embodiment, a Doherty power amplifier device may include an input, a power divider coupled to the input and configured to divide an input signal received from the input into a first signal and a second signal, a carrier amplification path configured to receive the first signal, and a peaking amplification path configured to receive the second signal. The carrier amplification path may include a carrier amplifier configured to amplify the first signal to produce a first amplified signal and phase slope adjustment circuitry coupled between the power divider and the carrier amplifier, the phase slope adjustment circuitry being configured to adjust a phase-dependent slope of a phase of the first signal. The peaking amplification path may include a peaking amplifier configured to amplify the second signal to produce a second amplified signal. The Doherty power amplifier device may include a combining node configured to combine first amplified signal and the second amplified signal to produce an output signal.

In one or more embodiments, the phase slope adjustment circuitry may include an input node, a first capacitor, a first inductor, an intermediate node, a second capacitor, a second inductor, an output node, a third capacitor, and a third inductor. The first capacitor and the first inductor may be coupled in series between the input node and the intermediate node. The second capacitor and the second inductor may be coupled in series between the intermediate node and the output node. The third capacitor and the third inductor may be coupled together in parallel between the intermediate node and a reference potential.

In one or more embodiments, the first inductor has a first inductance that is within 10% of a second inductance of the second inductor, the first capacitor has a first capacitance that is within 10% of a second capacitance of the second capacitor.

In one or more embodiments, the phase slope adjustment circuitry has a substantially linear phase response over a power frequency band of the Doherty power amplifier device.

In one or more embodiments, an insertion phase of the phase slope adjustment circuitry is 0 degrees at a center frequency of the Doherty power amplifier device.

In one or more embodiments, the phase slope adjustment circuitry has a frequency response corresponding to a constant-k bandpass filter.

In one or more embodiments, a center frequency of the Doherty power amplifier device is between 2 GHz and 2.5 GHz.

In one or more embodiments, a peak power of the Doherty power amplifier device is between 48 and 52 dBm, and an output power ripple of the Doherty power amplifier device is less than 0.2 dBm in a full power state.

In one or more embodiments, a quality factor of the phase slope adjustment circuitry is between 0.3 and 0.4.

In one or more embodiments, a bandwidth of the Doherty power amplifier device is between 850 MHz and 950 MHz.

In an example embodiment, an amplifier device may include a power divider configured to receive an input signal and divide the input signal into a first signal and a second signal, a first amplification path, a second amplification path, and a combining node. The first amplification path may include a first amplifier configured to amplify the first signal to produce a first amplified signal and phase slope adjustment circuitry coupled between the power divider and the first amplifier. The phase slope adjustment circuitry may be configured to adjust a phase-dependent slope of a phase of the first signal. The second amplification path may include a second amplifier configured to amplify the second signal to produce a second amplified signal and a combining node configured to combine first amplified signal and the second amplified signal to produce an output signal.

In one or more embodiments, the phase slope adjustment circuitry includes a bandpass filter.

In one or more embodiments, the bandpass filter of the phase slope adjustment circuitry includes an input node, a first capacitor, a first inductor, an intermediate node, a second capacitor, a second inductor, an output node, a third capacitor, and a third inductor. The first capacitor and the first inductor may be coupled in series between the input node and the intermediate node. The second capacitor and the second inductor may be coupled in series between the intermediate node and the output node. The third capacitor and the third inductor may be coupled together in parallel between the intermediate node and a reference potential.

In one or more embodiments, the first inductor has a first inductance that is within 10% of a second inductance of the second inductor, the first capacitor has a first capacitance that is within 10% of a second capacitance of the second capacitor.

In one or more embodiments, the bandpass filter of the phase slope adjustment circuitry has a substantially linear phase response over a power frequency band of the amplifier device.

In one or more embodiments, an insertion phase of the bandpass filter of the phase slope adjustment circuitry is 0 degrees at a center frequency of the amplifier device.

In one or more embodiments, a center frequency of the amplifier device is between 2 GHz and 2.5 GHz.

In one or more embodiments, a peak power of the amplifier device is between 48 and 52 dBm, and an output power ripple of the amplifier device is less than 0.2 dBm in a full power state.

In one or more embodiments, a quality factor of the bandpass filter of the phase slope adjustment circuitry is between 0.3 and 0.4.

In one or more embodiments, a bandwidth of the amplifier device is between 850 MHz and 950 MHz.

BRIEF DESCRIPTION OF THE DRAWINGS

A more complete understanding of the subject matter may be derived by referring to the detailed description and claims when considered in conjunction with the following figures, wherein like reference numbers refer to similar elements throughout the figures.

FIG 1 is a block diagram of an example radio frequency (RF) amplifier, according to various embodiments.

FIG. 2 is a block diagram of example phase slope adjustment circuitry that may be included in an RF amplifier, such as the RF amplifier of FIG. 1, according to various embodiments.

FIG. 3 shows charts illustrating insertion phase versus frequency and transmission loss versus frequency, respectively, given various Q-factors, for an RF amplifier that includes phase slope adjustment circuitry such as the phase slope adjustment circuitry of FIG. 2, according to various embodiments.

FIG. 4 shows charts illustrating peaking signal and carrier signal phase differences at inputs and outputs of an RF amplifier that includes phase slope adjustment circuitry, such as the phase slope adjustment circuitry of FIG. 2, and, separately, of an RF amplifier that does not include such phase slope adjustment circuitry, according to various embodiments.

FIG. 5 is a chart illustrating peak output power versus frequency for an RF amplifier that includes phase slope adjustment circuitry, such as the phase slope adjustment circuitry of FIG. 2, and, separately, of an RF amplifier that does not include such phase slope adjustment circuitry, according to various embodiments.

FIG. 6 is a top-down view of an example RF amplifier that includes phase slope adjustment circuitry, such as the phase slope adjustment circuitry of FIG. 2, implemented via surface mount components, according to various embodiments.

DETAILED DESCRIPTION

The following detailed description is merely illustrative in nature and is not intended to limit the embodiments of the subject matter or the application and uses of such embodiments. As used herein, the words "exemplary" and "example" mean "serving as an example, instance, or illustration." Any implementation described herein as exemplary or an example is not necessarily to be construed as preferred or advantageous over other implementations. Furthermore, there is no intention to be bound by any expressed or implied theory presented in the preceding technical field, background, or the following detailed description.

For the sake of brevity, conventional semiconductor fabrication techniques may not be described in detail herein. In addition, certain terminology may also be used herein for reference only, and thus are not intended to be limiting, and the terms "first", "second" and other such numerical terms referring to structures do not imply a sequence or order unless clearly indicated by the context.

As described herein, a radio frequency (RF) amplifier device having multiple amplification paths, such as a Doherty amplifier, may include phase slope adjustment circuitry at the input of one of the amplification paths (e.g., the "main" or "carrier" path), where the phase slope adjustment circuitry is configured to adjust the frequency-dependent phase slope of the signal on that amplification path (e.g., the carrier signal). For example, the bandwidth of a Doherty power amplifier (sometimes referred to herein as a "Doherty amplifier") is typically dependent on the impedance transformation ratios achieved through output combiner impedance transformers of the amplifier.

The characteristic impedance and electrical length of such impedance transformers typically deviate as a function of frequency.

Additionally, the bandwidth of a conventional Doherty amplifier may typically differ at different power states, such that a first bandwidth (i.e., "full power bandwidth") of the Doherty power amplifier at a "full" power state is different (typically smaller) than a second bandwidth (i.e., low power bandwidth) of the Doherty amplifier at a "low" power state. Herein, the "full power state" of a Doherty amplifier occurs when the carrier and peaking amplifiers of the Doherty amplifier are supplied with relatively high-power signals, which activate both the carrier amplifier and the peaking amplifier (e.g., supplying signals with power levels sufficient to cause both the carrier amplifier and the peaking amplifier to respectively deliver their maximum output power). For example, in the full power state, embodiments of the Doherty amplifier described herein may deliver around 100 W to 130 W (e.g., 125 W). Herein, the "low power state" of a Doherty amplifier occurs when supplying the carrier and peaking amplifiers of the Doherty amplifier with relatively low power signals, which cause the carrier amplifier to be active and the peaking amplifier to be off (e.g., supplying signals with power levels sufficient to turn on the carrier amplifier without activating the peaking amplifier). For example, for symmetrical Doherty amplifiers, the low power state may correspond to a power range of between 0 (no power) and the -6 dB output backoff (OBO) power level (e.g., around 44 dBm / 25 W in some embodiments). For example, for asymmetrical Doherty amplifiers, the low power state may correspond to a power range of between 0 (no power) and the -9 dB OBO power level (e.g., around 41 dBm / 12.5 W in some embodiments). Herein, the "bandwidth" of a given amplifier refers to the range of frequencies within which the output power of the amplifier meets or exceeds a predetermined threshold (e.g., around 51 dBm). This range of frequencies is sometimes referred to herein as the "power frequency band" of the amplifier. When operating at full power levels, the bandwidth of a Doherty amplifier may be limited by frequency-dependent phase misalignment between the carrier and peaking input paths of the amplifier. Such phase misalignment may be caused by differences in the input and output frequency deviations of the Doherty amplifier, which may occur in the full power state. As a result, there is a trade-off between the low power bandwidth and the full power bandwidth, which may undesirably limit the wideband RF performance of the conventional Doherty amplifier.

In accordance with various embodiments described below, phase slope adjustment circuitry is provided at the input side of the carrier path of a Doherty amplifier, which may improve alignment of the phase of the carrier signal with the phase of the peaking signal at the output combining node of the Doherty amplifier (e.g., by adjusting the phase of the carrier signal to be similar to that of the peaking signal through adjustment of the frequency-dependent phase slope of the carrier signal). The phase slope adjustment circuitry may include three or more resonant LC cells that may form a Pi or Tee network topology, for example. The phase slope adjustment circuitry may have a frequency response corresponding to that of a bandpass filter, such as a constant-k bandpass filter. The phase slope adjustment circuitry may be implemented using surface mount devices (SMDs) for capacitive components, inductive components, or both, which may improve tunability and reduce the footprint of the phase slope adjustment circuitry (e.g., compared to one or more other approaches to implementing the phase slope adjustment circuitry, such as a transmission-line-based implementation). The phase slope adjustment circuitry may reduce frequency dispersion of the load modulation of the Doherty amplifier in the full power state, while having little or no impact on the performance of the Doherty amplifier in the low power state.

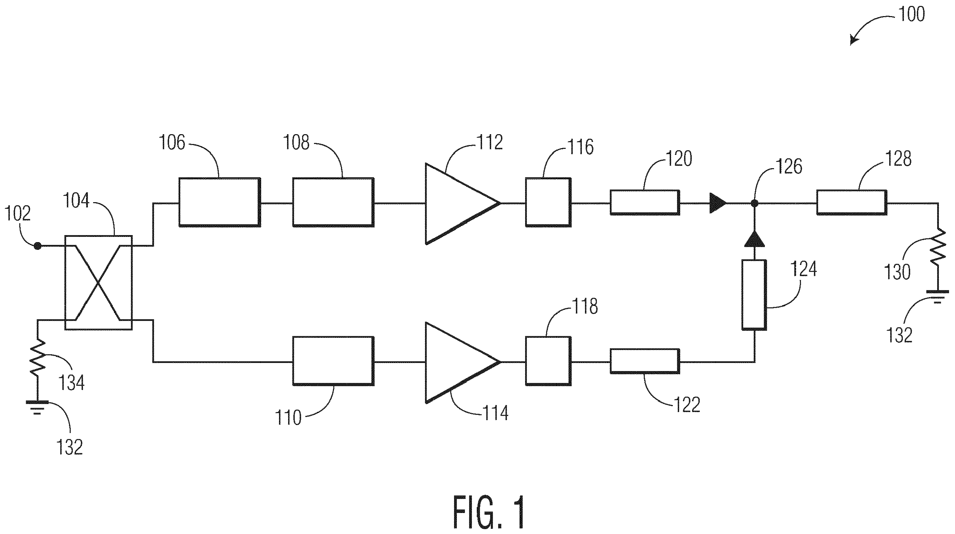

FIG. 1 is a block diagram illustrating a Doherty amplifier architecture. As illustrated, a Doherty amplifier device 100 (e.g., a Doherty power amplifier device) may include, at an input 102, a power divider 104. In one or more embodiments, the Doherty amplifier device 100 may be an asymmetric inverted Doherty power amplifier device. In one or more embodiments, the power divider 104 may be a 3 dB hybrid coupler with a first input for receiving an input radio frequency (RF) signal from the input 102, a second input coupled to a load (e.g., a 50 Ω load) and first and second output signals (sometimes referred to as the "carrier input signal" and the "peaking input signal"). For embodiments in which the Doherty amplifier device 100 corresponds to a symmetric Doherty amplifier, the power divider 104 may divide or split an input signal received at the input 102 into two signals that are similar with, in some embodiments, equal power or substantially equal power (e.g., each having power within around 10% of the power of the other). In one or more other embodiments, such as those in which the Doherty amplifier device corresponds to an asymmetric Doherty amplifier, power divider 104, may first and second output signals having unequal power. The power divider 104 may also apply a relative phase shift between first and second signals output from the power divider 104. For example, the power divider 104 may provide about a 90-degree relative phase shift to each of the carrier input signals (provided to a carrier amplifier 112 coupled along a carrier path of the Doherty amplifier device 100) so that that amplified carrier signals and amplified peaking signals received at an output combining node 126 may be received in phase (e.g., each amplified signal having a phase within 10% of that of the other).

The outputs of the power divider 104 are coupled to a carrier path that includes a carrier amplifier 112 and a peaking path that includes a peaking amplifier 114. The first output of the power divider 104 may be coupled to the carrier amplifier 112 via phase slope adjustment circuitry 106 and input impedance matching circuitry 108 (each coupled along the carrier path). The second output of the power divider 104 may be coupled to the peaking amplifier 114 via input impedance matching circuitry 110 (coupled along the peaking path). In one or more embodiments, the power divider 104 may have a third output that is coupled to a resistive load 134 (e.g., having a nominal impedance of 50 Ω). The resistive load 134 may be coupled between the third output of the power divider 104 and a reference potential 132 (sometimes referred to as "ground 132" or "ground potential 132"), may correspond to a reference voltage or ground voltage. Herein the term "potential", such as a reference potential or ground potential, refers to voltage potential unless noted otherwise. According to various embodiments, the carrier amplifier 112 and the peaking amplifier 114 each may include a respective single transistor or, alternatively, may include a respective system of components including multiple transistors. The carrier amplifier 112 and the peaking amplifier 114 may each include one or more stages of relatively low power level amplification and relatively high power-level amplification. The carrier amplifier may be a class AB amplifier. In some embodiments, the carrier amplifier 112 may be implemented by a network of electrical components, in which case, the carrier amplifier 112 may include an active device, which may be modeled as a current source. The peaking amplifier 114 implemented similarly to the carrier amplifier 112, with the exception of the peaking amplifier 114 being configured as a class C amplifier (e.g., having a lower bias voltage than class AB amplifiers such as the carrier amplifier 112).

In one or more embodiments, the RF signal provided to the carrier amplifier 112 (i.e., the "carrier input signal") from the power divider 104 and the RF signal provided to the peaking amplifier 114 (i.e., the "peaking input signal") from the power divider 104 may be respectively modulated at a predefined frequency. In one or more embodiments, the frequencies of the carrier input signal and the peaking input signal may each be in the range of 500 MHz to 7,500 MHz. According to various examples, the frequencies of the carrier input signal and the peaking input signal may each be in the range of 1,800 MHz-2,200 MHz, in the range of 1,800 MHz-2,700 MHz, or in the range of 2,300 MHz-2,700 MHz. In one or more other embodiments, the frequencies of the carrier input signal and the peaking input signal may each be at or above 7.7 GHz. The carrier amplifier 112 and the peaking amplifier 114 may each be configured to operate (e.g., amplify received signals) within respective operating frequency ranges that include the frequencies of the carrier input signal and the peaking input signal.

The output of the carrier amplifier 112 may be connected to the output combining node 126 through a carrier output path that includes an impedance transformer 120 (e.g., a quarter-wave impedance transformer). In some embodiments, output impedance matching circuitry 116 may also be coupled between the carrier amplifier 112 and the output combining node 126. The output of peaking amplifier 114 may be connected to the output combining node 126 through a peaking output path that includes a first impedance transformer 122 (e.g., a quarter-wave impedance transformer) and a second impedance transformer 124 (e.g., a quarter-wave impedance transformer). In some embodiments, the carrier path may have a 90° phase length, while the peaking path may have a 180° phase length. The output impedance matching circuitry 116 and the output impedance matching circuitry 118 may include inductive, capacitive, or resistive components (e.g., transmission lines, bond wires, SMDs, or the like) or a combination thereof, where such components may be arranged to reduce impedance mismatches between a load 130 and the carrier amplifier 112 and between the load 130 and the peaking amplifier 114, respectively. While, in the present example, the output impedance matching circuitry 116 is shown to be disposed between the carrier amplifier 112 and the impedance transformer 120 and the impedance matching circuitry 118 is shown to be disposed between the peaking amplifier 114 and the first impedance transformer 122, it should be understood that similar output impedance matching circuitry may additionally or alternatively be disposed at other locations between either of the peaking and carrier amplifiers 112, 114 and the output combining node 126 (e.g., interposed between the impedance transformer 120 and the output combining node 126, between the first impedance transformer 122 and the second impedance transformer 124, or between the second impedance transformer 124 and the output combining node 126) in one or more other embodiments.

The load 130 may be coupled between the output combining node 126 and the reference potential 132. The output impedance matching circuitries 116, 118 may also be configured remove noise (e.g., undesirable low frequency noise) from the respective RF signals output by the carrier amplifier 112 and the peaking amplifier 114 using one or more low-pass (to ground) and/or bandpass (to ground) filter circuits. In one or more embodiments, an impedance transformer 128 may be coupled between the output combining node 126 and the load 130.

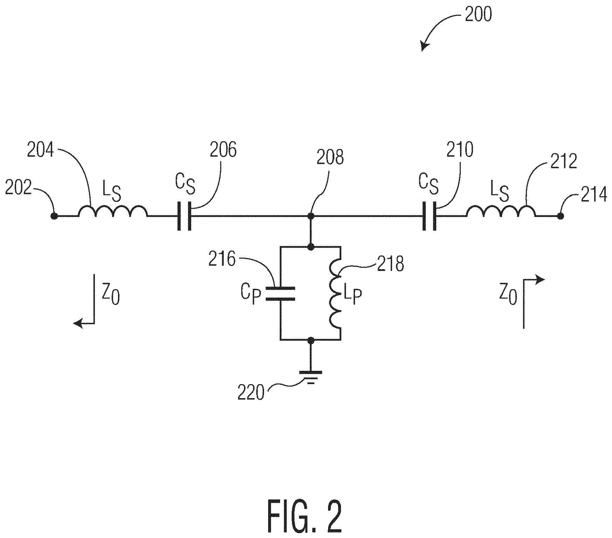

The phase slope adjustment circuitry 106 may be coupled between the power divider 104 and the carrier amplifier 112. The phase slope adjustment circuitry 106 may be a bandpass filter, such as a constant-k bandpass filter. In one or more embodiments, the phase slope adjustment circuitry 106 includes at least three resonant LC cells (each LC cell including a capacitor and an inductor arranged in parallel or in series) arranged in a Pi network topology or Tee network topology (e.g., the phase slope adjustment circuitry 200 of FIG. 2, described below). In one or more embodiments, the resonant LC cells of the phase slope adjustment circuitry 106 may be implemented using surface mount device (SMD) inductors and capacitors. By using SMDs to implement the resonant LC cells, the footprint of the phase slope adjustment circuitry 106 may be reduced compared to, for example, approaches in which the resonant LC cells are implemented via an arrangement of 90° transmission lines and/or 90° short-circuited stubs.

The phase slope adjustment circuitry 106 may have a linear or substantially linear (e.g., corresponding to an R-squared value of greater than 0.95 in the context of a linear regression model) phase response over an operating frequency band (e.g., a range of around 1.7 GHz to around 2.7 GHz) of the Doherty amplifier 100. The phase slope adjustment circuitry 106 may be configured to adjust the phase slope of received carrier signals. For example, by adjusting the phase slope of a given carrier signal using the phase slope adjustment circuitry 106, the phase difference between amplified carrier signals and amplified peaking signals at the output combining node 126 may be advantageously reduced, which may reduce frequency dispersion of load modulation and improve wideband RF performance of the Doherty amplifier 100 in its full power state (e.g., a power level of around 50 dBm +/- 1.5 dBm).

FIG. 2 shows an illustrative circuit diagram of phase slope adjustment circuitry 200. In one or more embodiments, the phase slope adjustment circuitry 200 may correspond to the phase slope adjustment circuitry 106 of FIG. 1. As shown, the phase slope adjustment circuitry 200 may be arranged as a tee network of resonant LC cells. The phase slope adjustment circuitry 200 may include an input node 202, a first inductor 204 having an inductance Ls, a first capacitor 206 having a capacitance Cs, an intermediate node 208, a second capacitor 210 having a capacitance Cs (e.g., a capacitance that is the same or substantially the same as that of the first capacitor 206), a second inductor 212 having an inductance Ls (e.g., an inductance that is the same or substantially the same as that of the first inductor 204), an output node 214 a third capacitor 216 having a capacitance $C_P$, and a third inductor 218 having an inductance $L_P$. The first inductor 204 and the first capacitor 206 correspond to a first resonant LC cell coupled in series between the input node 202 and the intermediate node 208. The second inductor 212 and the second capacitor 210 correspond to a second resonant LC cell coupled in series between the intermediate node 208 and the output node 214. The third inductor 218 and the third capacitor 216 correspond to a third resonant LC cell coupled between the intermediate node 208 and a reference potential 220 (e.g., corresponding to a ground voltage or reference voltage; sometimes referred to as "ground potential 220" or "ground 220") in a parallel arrangement. Each of the input impedance magnitude and output impedance magnitude of the phase slope adjustment circuitry 200 may be Zo, which may be around 50 Ω (e.g., 50 Ω +/- 5Ω).

The phase slope adjustment circuitry 200 may be configured to change the frequency-dependent phase slope of signals (e.g., carrier signals) received at the input node 202. The magnitude by which the frequency-dependent phase slope of such signals is adjusted by the phase slope adjustment circuitry 200 may be dependent on the quality-factor (sometimes denoted herein as "Q" or "Q-factor") of filter implemented via the phase slope adjustment circuitry 200, which is related to the inductance values $L_S$ and Lp and the capacitance values Cs and $C_P$. For example, the capacitance value Cs of the first and second capacitors 206 and 210 may be determined using Equation 1:

$$C_S = \frac{2/Q}{4\pi * F_C * Z_0} \qquad \text{EQ. 1,}$$

where Q is the quality factor, Fc is the center frequency of the amplifier that includes the phase adjustment circuitry 200 (e.g., the Doherty amplifier 100 of FIG. 1), and Zo is the characteristic impedance (e.g., 50 Ω). The capacitance value $C_P$ of the third capacitor 216 may be determined using Equation 2:

$$C_P = \frac{1}{\pi * Z_0 * (F_C/Q)} \qquad \text{EQ. 2.}$$

The inductance value Ls of the first and second inductors 204 and 212 may be determined using Equation 3:

$$L_S = \frac{Z_0}{2\pi * (F_C/Q)} \qquad \text{EQ. 3.}$$

The inductance value Ls of the first and second inductors 204 and 212 may be determined using Equation 4:

$$L_P = \frac{Z_0/Q}{4\pi * F_C} \qquad \text{EQ. 4.}$$

Example theoretical values of Q and corresponding theoretical values of Cs, $C_P$, Ls, and $L_P$, given a center frequency Fc of 2.25 GHz and a characteristic impedance magnitude Zo of 50 Ω, are provided in Table 1, below:

TABLE 1

| Q | $C_S$ (F) | $L_S$ (H) | $C_P$ (F) | $L_P$ (H) |
|---|---|---|---|---|
| 0.2 | 7.1E-12 | 7.1E-10 | 5.7E-13 | 8.8E-9 |
| 0.4 | 3.5E-12 | 1.4E-9 | 1.1E-12 | 4.4E-9 |
| 0.6 | 2.4E-12 | 2.1E-9 | 1.7E-12 | 2.9E-9 |
| 0.8 | 1.8E-12 | 2.8E-9 | 2.3E-12 | 2.2E-9 |
| 1.0 | 1.4E-12 | 3.5E-9 | 2.8E-12 | 1.8E-9 |
| 1.2 | 1.2E-12 | 4.2E-9 | 3.4E-12 | 1.5E-9 |

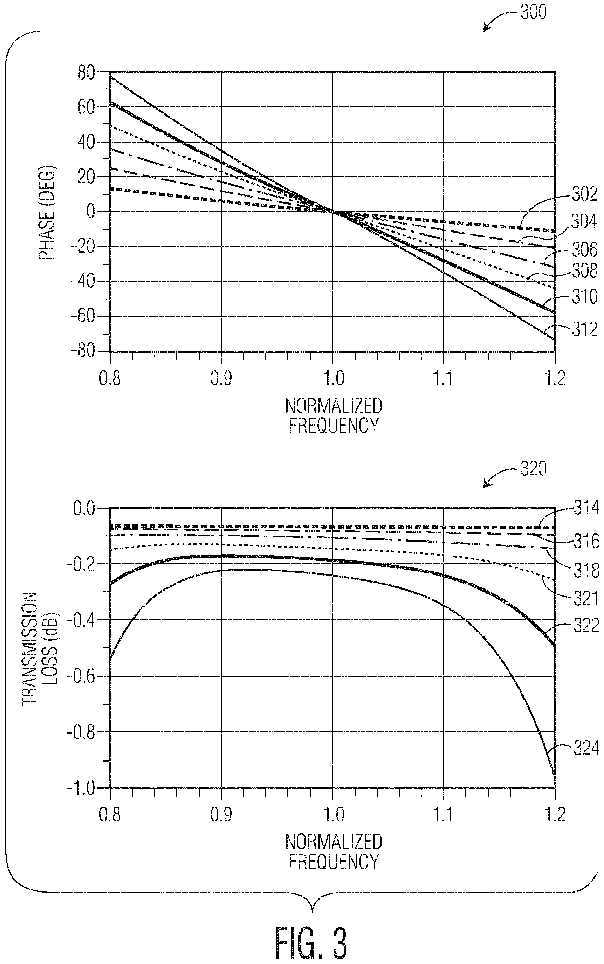

FIG. 3 shows a chart 300 illustrating the phase response versus normalized frequency for an embodiment of the phase slope adjustment circuitry 200 of FIG. 2 for multiple Q-factor values and a chart 320 illustrating transmission loss versus normalized frequency for an embodiment of the phase slope adjustment circuitry 200 of FIG. 2 for multiple Q-factor values. In the examples of the charts 300 and 320, examples of inductance and capacitance values (e.g., the values of Cs, $C_P$, $L_S$, and Lp for the inductors 204, 212, 218 and the capacitors 206, 210, 216 of the phase slope adjustment circuitry 200 of FIG. 2) that may be used to achieve the Q-factor values associated with each curve are given in the example of Table 1, above.

The chart 300 shows a curve 302 corresponding to a Q-factor of 0.2, a curve 304 corresponding to a Q-factor of 0.4, a curve 306 corresponding to a Q-factor of 0.6, a curve 308 corresponding to a Q-factor of 0.8, a curve 310 corresponding to a Q-factor of 1.0, and a curve 312 corresponding to a Q-factor of 1.2. Given an embodiment of the phase slope adjustment circuitry 200 that utilizes the capacitance and inductance values of Table 1 to achieve the Q-factor values represented in the chart 300, the normalized frequency of 1.0 corresponds to a center frequency of 2.25 GHz, for example.

As shown, each of the curves 302, 304, 306, 308, 310, 312 are linear or substantially linear and have respectively negative slopes (e.g., with the phase shift decreasing with increasing frequency). Additionally, each of the curves 302, 304, 306, 308, 310, 312 shows that, for each if the respective Q-factor values represented thereby, there is zero or substantially zero phase shift (i.e., insertion phase) at the normalized frequency value of 1.0 (e.g., which may represent the center frequency of a Doherty amplifier that includes the phase slope adjustment circuitry 200 of FIG. 2, such as the Doherty amplifier 100 of FIG. 1). At least because the insertion phase at the center frequency (i.e., the normalized frequency of 1.0) is zero or substantially zero for each of the Q-factor values represented in the curves 302, 304, 306, 308, 310, 312, the phase slope adjustment circuitry 200 may effectively change the frequency-dependent slope of received signals (e.g., carrier signals) with a magnitude that is relative to the Q-factor value used (e.g., with higher Q-factor value corresponding to a greater change in the slope).

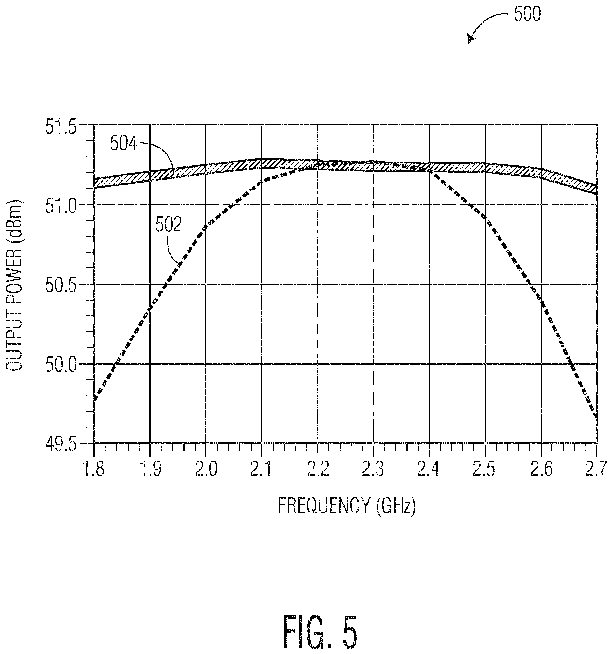

In this way, by the frequency-dependent phase slope of carrier signals in a Doherty amplifier that includes the phase slope adjustment circuitry 200 may be better aligned with that of peaking signals of the Doherty amplifier (e.g., at the output combining node 126 of FIG. 1) by selectively tuning component values (e.g., the values of Cs, $C_P$, Ls, and $L_P$ for the inductors 204, 212, 218 and the capacitors 206, 210, 216) to achieve a Q-factor values associated with a desired magnitude of shift in the phase slope. By improving the alignment between the phase of the carrier signals and peaking signals of a Doherty amplifier, the bandwidth of the Doherty amplifier in the full power state may be improved. That is, the full power frequency band of the Doherty amplifier may be increased (e.g., from around 2 GHz - 2.5 GHz to around 1.8 GHz to around 2.7 GHz in the example of FIG. 5, below). It should be noted that the phase slope adjustment circuitry 200 may have little or no effect on the bandwidth of the corresponding Doherty amplifier in the low power state, while improving the bandwidth of the Doherty amplifier in the full power state.

The chart 320 shows a curve 314 corresponding to a Q-factor of 0.2, a curve 316 corresponding to a Q-factor of 0.4, a curve 318 corresponding to a Q-factor of 0.6, a curve 321 corresponding to a Q-factor of 0.8, a curve 322 corresponding to a Q-factor of 1.0, and a curve 324 corresponding to a Q-factor of 1.2. As shown, as the Q-factor value of the phase slope adjustment circuitry 200 increases, the amount of transmission loss attributable to the phase slope adjustment circuitry 200 increases with distance from the center frequency. This shows that the Q-factor value may define the upper and lower cut-off frequencies for the bandpass filter implemented via the phase slope adjustment circuitry 200, indicating that the amount of phase slope adjustment achievable using the phase slope adjustment circuitry 200 may be limited by the amount of bandwidth desired for the Doherty amplifier in the full power state.

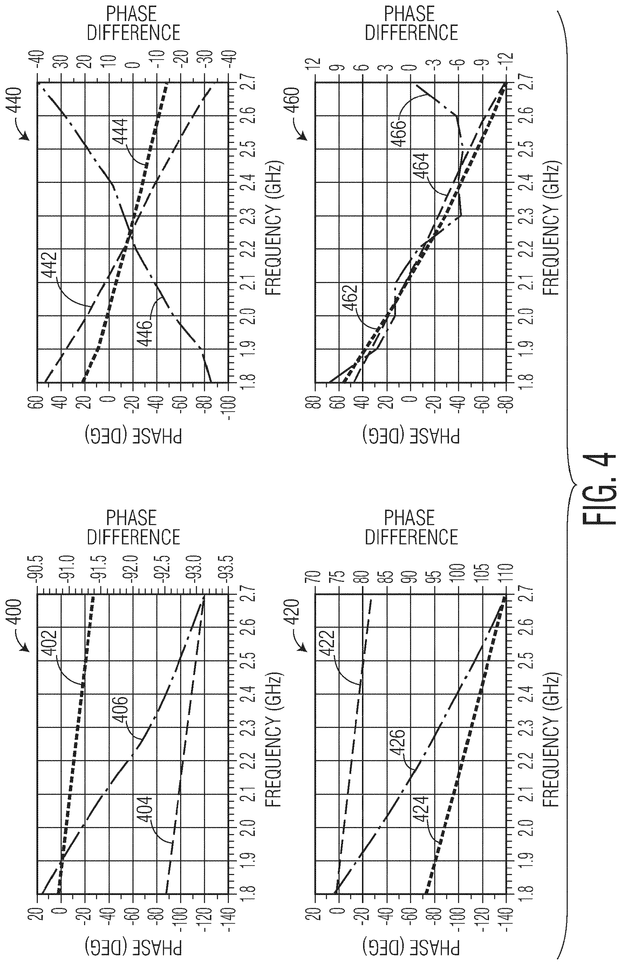

FIG. 4 shows multiple charts illustrating phase differences between carrier signal and peaking signals before amplification and, separately, at the combining node (e.g., the output combining node 126 of FIG. 1) for a Doherty amplifier (e.g., the Doherty amplifier 100 of FIG. 1) that includes an embodiment of the phase slope adjustment circuitry 200 of FIG. 2 and, separately, for a Doherty amplifier that does not include such phase slope adjustment circuitry. Chart 400 shows frequency-dependent carrier signal and peaking signal phase differences prior to amplification in a Doherty amplifier that does not include phase slope adjustment circuitry. Chart 420 shows frequency-dependent carrier signal and peaking signal phase differences prior to amplification in a Doherty amplifier that includes an embodiment of the phase slope adjustment circuitry 200. Chart 440 shows frequency-dependent phase difference between carrier signal and peaking signal phase differences at the combining node of a Doherty amplifier (i.e., after amplification) that does not include phase slope adjustment circuitry. Chart 460 shows frequency-dependent phase difference between carrier signal and peaking signal phase differences at the combining node of a Doherty amplifier (i.e., after amplification) that includes an embodiment of the phase slope adjustment circuitry 200. In the present example, each Doherty amplifier respectively represented in the charts 400, 420, 440, 460, has a center frequency of around 2.25 GHz and around 125 W peak power, though it should be understood that this is intended to be illustrative and not limiting. The phase slope adjustment circuitry of the Doherty amplifier represented in the charts 420 and 460 may have a Q-factor value of around 0.48 and a Zo value of around 50 Ω.

As shown in the chart 400, in a Doherty amplifier without phase slope adjustment circuitry and prior to amplification, the frequency-dependent phase slope of the peaking signal, represented by curve 402, is around -25 degrees / GHz, and the frequency-dependent phase slope of the carrier signal, represented by curve 404, is around -30 degrees / GHz. The phase difference between the carrier signal and the peaking signal (i.e., the phase difference between the curve 402 and the curve 404) is represented by the curve 406, which ranges from around -90.5 degrees to around -93 degrees from 1.8 GHz to 2.7 GHz.

As shown in the chart 420, in a Doherty amplifier with an embodiment of the phase slope adjustment circuitry 200 and prior to amplification, the frequency-dependent phase slope of the peaking signal, represented by curve 422, is around -25 degrees / GHz (no change compared to the example of the chart 400), and the frequency-dependent phase slope of the carrier signal, represented by curve 424, is around -63 degrees / GHz. Compared to the curve 404 in example of the chart 400, the magnitude of the phase slope of the carrier signal represented by the curve 424 is increased by around 30 degrees due to the phase slope adjustment circuitry. The phase difference between the carrier signal and the peaking signal (i.e., the phase difference between the curve 402 and the curve 404) is represented by the curve 426, which ranges from around -75 degrees to around -110 degrees from 1.8 GHz to 2.7 GHz. By increasing the magnitude of the phase slope of the carrier signal prior to amplification using the phase slope adjustment circuitry in this way, the alignment of the frequency-dependent phase curves of the carrier and peaking signals is improved at the combining node of the Doherty amplifier, as can be shown via comparison of the charts 440 and 460.

As shown in the chart 440, at the combining node of a Doherty amplifier without phase slope adjustment circuitry (following amplification of the carrier signal and peaking signal), the amplified peaking signal, represented by curve 442, has a frequency-dependent phase slope of around -135 degrees / GHz, and the frequency-dependent phase slope of the amplified carrier signal, represented by curve 444, is around -65 degrees / GHz. This results in a relatively large variation in frequency-dependent phase difference between the amplified carrier signal and the amplified peaking signal at the combining node, as represented by the curve 446 which ranges from around -30 degrees to around 40 degrees from 1.8 GHz to 2.7 GHz. While the respective phases of the amplified carrier signal and the amplified phase signal in the example of the chart 440 are similar near the center frequency of 2.25 GHz, the magnitude of phase difference increases at frequencies further from the center frequency, and such phase misalignment between the amplified carrier signal and the amplified peaking signal undesirably degrades output power of the Doherty amplifier at these frequencies, which limits the operational bandwidth of the Doherty amplifier.

As shown in the chart 460, at the combining node (e.g., the output combining node 126 of FIG. 1) of a Doherty amplifier with an embodiment of the phase slope adjustment circuitry 200 (following amplification of the carrier signal and peaking signal), the amplified peaking signal, represented by curve 462, has a frequency-dependent phase slope of around -135 degrees / GHz, and the frequency-dependent phase slope of the amplified carrier signal, represented by curve 444, is around -125 degrees / GHz. This corresponds to a comparatively smaller variation in frequency-dependent phase difference between the amplified carrier signal and the amplified peaking signal at the combining node, as represented by the curve 466 which ranges from around 10 degrees to around -6 degrees over the range of 1.8 GHz to 2.7 GHz. As shown in the chart 460, compared to curve 446 of the chart 440, the frequency-dependent phase difference between the amplified carrier signal and the amplified peaking signal at the combining node represented by the curve 466 for a Doherty amplifier that includes the phase slope adjustment circuitry 200 is lower in magnitude across a wider frequency band (e.g., between 1.8 GHz to 2.7 GHz) than that of a Doherty amplifier that does not include such phase slope adjustment circuitry. That is, the adjustment to the frequency-dependent phase slope enacted by the phase slope adjustment circuitry 200 and represented in the chart 420 may cause a reduction in frequency-dependent phase misalignment between the amplified carrier signal and the amplified peaking signal, thereby improving output power of the Doherty amplifier over the wider frequency band, which improves operational bandwidth of the Doherty amplifier.

FIG. 5 shows a chart 500 illustrating output power versus frequency for a Doherty amplifier without phase slope adjustment circuitry (e.g., the Doherty amplifier represented in charts 400 and 440 of FIG. 4) and, separately, a Doherty amplifier with phase slope adjustment circuitry, such as an embodiment of the phase slope adjustment circuitry 200 of FIG. 2 (e.g., the Doherty amplifier 100 of FIG. 1; the Doherty amplifier represented in the charts 420 and 460 of FIG. 4). The output power of the Doherty amplifier without phase slope adjustment circuitry is represented by a curve 502. The output power of the Doherty amplifier with phase slope adjustment circuitry is represented by a curve 504. In the present example, each respective Doherty amplifier corresponding to the curves 502 and 504 has a center frequency of around 2.25 GHz and around 125 W to 130 W peak power, though it should be understood that this is intended to be illustrative and not limiting. The phase slope adjustment circuitry of the Doherty amplifier represented by the curve 504 may have a Q-factor value of around 0.48 and a Zo value of around 50 Ω.

The output power of the Doherty amplifier without phase slope adjustment circuitry (represented by the curve 502) may decline with increasing distance from the center frequency (2.25 GHz in the present example) due to phase misalignment between the amplified carrier signal and the amplified peaking signal at the output combining node, which increases in magnitude is distance from the center frequency increases. In contrast, the output power of the Doherty amplifier with phase slope adjustment circuitry may be comparatively stable, with the output power remaining above 51 dBm over the 1.8 GHz to 2.7 GHz frequency band. Comparison between the curve 502 and the curve 504 illustrates the impact of phase slope adjustment circuitry in a Doherty amplifier when configured to reduce frequency-dependent phase misalignment between the amplified carrier signal and the amplified peaking signal at the output combining node (as shown in the charts 420 and 460 of FIG. 4), in that such a reduction in frequency-dependent phase misalignment may increase the output power of a corresponding Doherty amplifier across a given frequency band, thereby increasing the functional operating frequency band of the Doherty amplifier.

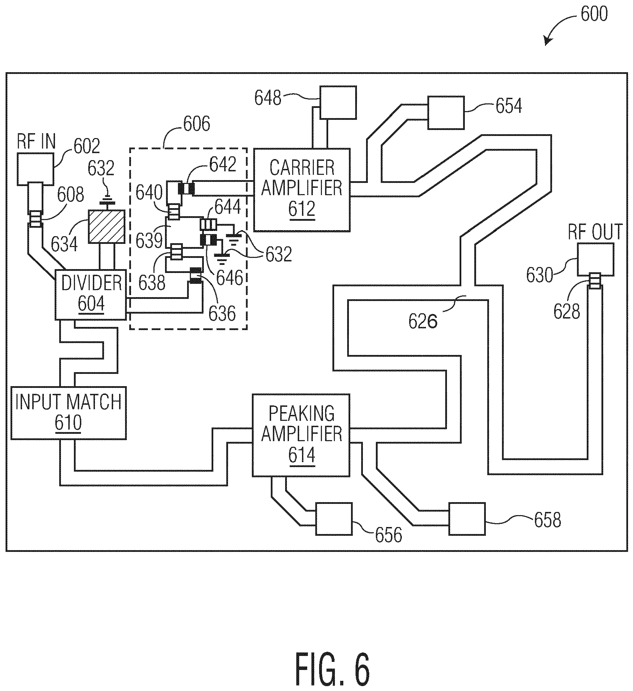

FIG. 6 shows an illustrative top-down view of a Doherty amplifier 600 (e.g., an embodiment of the Doherty amplifier 100 of FIG. 1) that includes phase slope adjustment circuitry 606 (e.g., an embodiment of the phase slope adjustment circuitry 200 of FIG. 2). In the present example, the Doherty amplifier 600 includes an RF input 602 that receives RF input signals, a power divider 604 (e.g., a 3 dB hybrid coupler), the phase slope adjustment circuitry 606, a carrier amplifier 612, input impedance matching circuitry 610, a peaking amplifier 614, an output combining node 626 and an RF output 630.

The power divider 604 may have a first input that receives RF input signals from the RF input 602. A direct-current (DC) blocking capacitor 608 may be coupled between the RF input 602 and the first input of the power divider 604. The conductive path between the RF input 602 and the power divider 604 may be referred to as the "input path" of the Doherty amplifier 600.

The power divider 604 may have a first output coupled to the peaking amplifier 614 via the input impedance matching circuitry 610. The conductive path between the first output of the power divider 604 and the peaking amplifier 614 may be referred to as the "peaking input path" of the Doherty amplifier 600.

The power divider 604 may have a second output coupled to the carrier amplifier 612 via the phase slope adjustment circuitry 606. The conductive path between the second output of the power divider 604 and the carrier amplifier 612 may be referred to as the "carrier input path" of the Doherty amplifier 600. The power divider 604 may be configured to symmetrically or asymmetrically divide a given input signal into a peaking signal and a carrier signal having the same (in the symmetrical case) or different (in the asymmetrical case) signal power with respect to one another, in accordance with various embodiments. The peaking signal may be provided to the peaking amplifier 614 along the peaking path from the first output of the power divider 604. The carrier signal may be provided to the carrier amplifier 612 along the carrier path from the second output of the power divider 604.

The power divider 604 may have a third output coupled to a reference potential 632 (sometimes referred to herein as a "ground 632" or "ground potential 632") via a resistive load 634 (e.g., the resistive load 134 of FIG. 1). For example, the resistive load 634 may have an impedance of around 50 Ω.

The carrier amplifier 612 may have an output that is coupled to the output combining node 626 and to a drain bias pad 654. The drain bias pad 654 may be coupled to a drain bias voltage source that is configured to supply a drain bias voltage to drain terminals of transistors of the carrier amplifier 612. The conductive path between the carrier amplifier 612 and the output combining node 626 may be referred to as the "carrier output path" of the Doherty amplifier 600.

The carrier amplifier 612 may be coupled to a gate bias pad 648. The gate bias pad 648 may be coupled to a gate bias voltage source configured to supply a gate bias voltage to gate terminals of transistors of the carrier amplifier 612.

The peaking amplifier 614 may have an output that is coupled to the output combining node 626 and to a drain bias pad 658. The drain bias pad 658 may be coupled to a drain bias voltage source that is configured to supply a drain bias voltage to drain terminals of transistors of the peaking amplifier 614. The conductive path between the peaking amplifier 614 and the output combining node 626 may be referred to as the "peaking output path" of the Doherty amplifier 600.

The peaking amplifier may have an output that is coupled to a gate bias pad 656. The gate bias pad 656 may be coupled to a gate bias voltage source configured to supply a gate bias voltage to gate terminals of transistors of the peaking amplifier 614.

The carrier amplifier 612 and the peaking amplifier 614 may each, respectively, include a transistor device, which may include an array of transistors arranged in parallel. Each of the parallel transistors of the carrier amplifier 612 may include a control terminal (e.g., a gate terminal) coupled to the input of the carrier amplifier 612 a first current terminal (e.g., a source terminal) coupled to the ground potential 632, and a second current terminal (e.g., a drain terminal) coupled to the output of the carrier amplifier 612. Each of the parallel transistors of the peaking amplifier 614 may include a control terminal (e.g., a gate terminal) coupled to the input of the peaking amplifier 614 a first current terminal (e.g., a source terminal) coupled to the ground potential 632, and a second current terminal (e.g., a drain terminal) coupled to the output of the peaking amplifier 614.

In one or more embodiments, the transistors of either or both of the carrier amplifier 612 and the peaking amplifier 614 may be LDMOS FETS. In one or more other embodiments, such transistors may be BJTs, MESFETs, HBTs, or HEMTs. According to various embodiments, the transistors of either or both of the carrier amplifier 612 and the peaking amplifier 614 may include silicon (e.g., as with a silicon LDMOS FET or a silicon bipolar transistor), a III-V material such as GaAs (e.g., as with a GaAs MESFET), InGaP (e.g., as with an InGaP HBT), or GaN (e.g., as with a GaN HEMT or GaN bipolar transistor).

The output combining node 626 may be configured to combine amplified peaking signals and amplified carrier signals output by the peaking amplifier 614 and the carrier amplifier 612, respectively. The output combining node 626 may be coupled to the RF output 630. The conductive path that connects the output combining node 626 to the RF output 630 may be referred to as the "output path" of the Doherty amplifier 600.

A direct-current (DC) blocking capacitor 628 may be coupled between the RF output 630 and the output combining node 626. In one or more embodiments, one or more shunt capacitors (not shown) may be coupled between the conductive traces and the ground potential 632 at various points along the input, peaking, carrier, and output paths of the Doherty amplifier 600.

The phase slope adjustment circuitry 606 (e.g., which may be an embodiment of the phase slope adjustment circuitry 200 of FIG. 2) may include a first resonant LC cell that includes a capacitor 638 (e.g., the capacitor 206 of FIG. 2) coupled in series with an inductor 636 (e.g., the inductor 204 of FIG. 2), a second resonant LC cell that includes a capacitor 640 (e.g., the capacitor 210 of FIG. 2) coupled in series with an inductor 642 (e.g., the inductor 212 of FIG. 2), and a third resonant LC cell that includes a capacitor 644 (e.g., the capacitor 216 of FIG. 2) coupled in parallel with an inductor 646 (e.g., the inductor 218 of FIG. 2). The first resonant LC cell may be coupled between the power divider 604 and an intermediate conductive trace 639. The second resonant LC cell may be coupled between the intermediate conductive trace 639 and an input of the carrier amplifier 612. The third resonant LC cell may be coupled between the intermediate conductive trace and the ground potential 632. As shown, each of the capacitors 638, 640, 644 and the inductors 636, 642, 646 may be SMD components, which provides an advantageously reduced form factor for the phase slope adjustment circuitry 606 compared to, for example, attempting to achieve similar functionality with quarter wave impedance transformers. The component values (e.g., capacitance values and inductance values) of the capacitors 638, 640, 644 and the inductors 636, 642, 646 of the phase slope adjustment circuitry 606 may be selected similarly to those of corresponding components of the phase slope adjustment circuitry 200 of FIG. 2, as described above and in connection with Table 1. As an example, given a characteristic impedance (Z0) value of 50 Ω, a center frequency of 2.2 GHz, and a target Q-factor value of 0.35, the capacitors 638 and 640 may each have a capacitance of around 3.4 pF, the capacitor 644 may have a capacitance of around 0.9 pF, the inductors 636 and 64 may each have an inductance of around 1.2 nH, and the inductor 646 may have an inductance of around 4.8 nH.

The phase slope adjustment circuitry 606 may be configured to change the frequency-dependent phase slope of carrier signals output from the power divider 604, which may reduce phase misalignment between amplified carrier signals and amplified peaking signals at the output combining node 626, thereby improving the full power operational bandwidth of the Doherty amplifier 600, (e.g., as illustrated in the charts 300, 420, 460, and 500 of FIGS. 3, 4, and 5).

It should be understood that the widths of the conductive traces in the present example are shown to be substantially equal with respect to one another. However, in one or more embodiments, the widths of such conductive traces may vary at different points along the input, carrier, peaking, and output paths shown (e.g., with conductive traces at inputs and outputs of the carrier and/or peaking amplifiers being comparatively wider than shown here).

An amplifier device having multiple amplification paths, such as a Doherty amplifier device, may include phase slope adjustment circuitry configured to adjust the frequency-dependent slope of the phase of an input carrier signal along a carrier path of the amplifier. By adjusting the phase slope of the input carrier signal in this way, the phase difference between carrier and peaking signals at an output combining node of the amplifier may be reduced, thereby reducing output power ripple of the amplifier. The phase slope adjustment circuitry may be a constant-k bandpass filter. The phase slope adjustment circuitry may have a zero-degree insertion phase at the center frequency of the amplifier. The phase slope adjustment circuitry may be implemented using surface mount inductors and capacitors.

The foregoing description refers to elements or nodes or features being "connected" or "coupled" together. As used herein, unless expressly stated otherwise, "connected" means that one element is directly joined to (or directly communicates with) another element, and not necessarily mechanically. Likewise, unless expressly stated otherwise, "coupled" means that one element is directly or indirectly joined to (or directly or indirectly communicates with) another element, and not necessarily mechanically. Thus, although the schematic shown in the figures depict one exemplary arrangement of elements, additional intervening elements, devices, features, or components may be present in an embodiment of the depicted subject matter.

While at least one embodiment has been presented in the foregoing detailed description, it should be appreciated numerous acceptable variations are possible. It should also be appreciated that the exemplary embodiment or embodiments described herein are not intended to limit the scope, applicability, or configuration of the claimed subject matter in any way. Rather, the foregoing detailed description will provide those skilled in the art with a convenient road map for implementing the described embodiment or embodiments. It should be understood that various changes can be made in the function and arrangement of elements without departing from the scope defined by the claims, which includes known equivalents and foreseeable equivalents at the time of filing this patent application.

**Claims**

1. A Doherty power amplifier device comprising:

    an input;
    a power divider coupled to the input and configured to divide an input signal received from the input into a first signal and a second signal;
    a carrier amplification path configured to receive the first signal, the carrier amplification path comprising:

        a carrier amplifier configured to amplify the first signal to produce a first amplified signal; and
        phase slope adjustment circuitry coupled between the power divider and the carrier amplifier, wherein the phase slope adjustment circuitry is configured to adjust a phase-dependent slope of a phase of the first signal;

    a peaking amplification path configured to receive the second signal, the peaking amplification path comprising:
    a peaking amplifier configured to amplify the second signal to produce a second amplified signal; and
    a combining node configured to combine first amplified signal and the second amplified signal to produce an output signal.

2. The Doherty power amplifier device of claim 1, wherein the phase slope adjustment circuitry comprises:

    an input node;
    a first capacitor;
    a first inductor;
    an intermediate node, wherein the first capacitor and the first inductor are coupled in series between the input node and the intermediate node;
    a second capacitor;
    a second inductor;
    an output node, wherein the second capacitor and the second inductor are coupled in series between the intermediate node and the output node;
    a third capacitor; and
    a third inductor, wherein the third capacitor and the third inductor are coupled together in parallel between the intermediate node and a reference potential.

3. The Doherty power amplifier device of claim 2, wherein the first inductor has a first inductance that is within 10% of a second inductance of the second inductor, the first capacitor has a first capacitance that is within 10% of a second capacitance of the second capacitor.

4. The Doherty power amplifier device of any of claims 2 or 3, wherein the phase slope adjustment circuitry has a substantially linear phase response over a power frequency band of the Doherty power amplifier device.

5. The Doherty power amplifier device of claim 4, wherein an insertion phase of the phase slope adjustment circuitry is 0 degrees at a center frequency of the Doherty power amplifier device.

6. The Doherty power amplifier device of any preceding claim, wherein the phase slope adjustment circuitry has a frequency response corresponding to a constant-k bandpass filter.

7. The Doherty power amplifier device of any preceding claim, wherein a center frequency of the Doherty power amplifier device is between 2 GHz and 2.5 GHz.

8. The Doherty power amplifier device of any preceding claim, wherein a peak power of the Doherty power amplifier device is between 48 and 52 dBm, and an output power ripple of the Doherty power amplifier device is less than 0.2 dBm in a full power state.

9. The Doherty power amplifier device of any preceding claim, wherein a quality factor of the phase slope adjustment circuitry is between 0.3 and 0.4.

10. The Doherty power amplifier device of any preceding claim, wherein a bandwidth of the Doherty power amplifier device is between 850 MHz and 950 MHz.

11. An amplifier device comprising:

    a power divider configured to receive an input signal and divide the input signal into a first signal and a second signal;
    a first amplification path comprising:

        a first amplifier configured to amplify the first signal to produce a first amplified signal; and
        phase slope adjustment circuitry coupled between the power divider and the first amplifier, wherein the phase slope adjustment circuitry is configured to adjust a phase-dependent slope of a phase of the first signal;

a second amplification path comprising:
a second amplifier configured to amplify the second signal to produce a second amplified signal; and
a combining node configured to combine first amplified signal and the second amplified signal to produce an output signal.

**12.** The amplifier device of claim 11, wherein the phase slope adjustment circuitry comprises a bandpass filter.

**13.** The amplifier device of claim 12, wherein the bandpass filter of the phase slope adjustment circuitry comprises:

an input node;
a first capacitor;
a first inductor;
an intermediate node, wherein the first capacitor and the first inductor are coupled in series between the input node and the intermediate node;
a second capacitor;
a second inductor;
an output node, wherein the second capacitor and the second inductor are coupled in series between the intermediate node and the output node;
a third capacitor; and
a third inductor, wherein the third capacitor and the third inductor are coupled together in parallel between the intermediate node and a reference potential.

**14.** The amplifier device of claim 13, wherein the first inductor has a first inductance that is within 10% of a second inductance of the second inductor, the first capacitor has a first capacitance that is within 10% of a second capacitance of the second capacitor.

**15.** The amplifier device of any of claims 12 to 14, wherein the bandpass filter of the phase slope adjustment circuitry has a substantially linear phase response over a power frequency band of the amplifier device.

FIG. 1

FIG. 2

FIG. 3

FIG. 4

FIG. 5

FIG. 6

Europäisches
Patentamt

European
Patent Office

Office européen
des brevets

# EUROPEAN SEARCH REPORT

Application Number

EP 22 30 6454

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | RUI-JIA LIU ET AL: "Bandwidth-extended single-input switchable Doherty power amplifier based on dual compensating reactance with adjusted drain voltage", IET MICROWAVES, ANTENNAS & PROPAGATION, THE INSTITUTION OF ENGINEERING AND TECHNOLOGY, UNITED KINGDOM, vol. 15, no. 12, 2 July 2021 (2021-07-02), pages 1577-1593, XP006112261, ISSN: 1751-8725, DOI: 10.1049/MIA2.12170 * page 1577, left-hand column, line 2 - page 1591, left-hand column, line 14; figures 1-23 * | 1-15 | INV. H03F1/02 H03F1/32 H03F1/56 H03F3/195 |
| X | HYUKYONG KWON ET AL: "A study on efficiency improvement of Doherty amplifier using LDMOS FET for WiMax networks", ADVANCED COMMUNICATION TECHNOLOGY, 2009. ICACT 2009. 11TH INTERNATIONAL CONFERENCE ON, GIRI, PISCATAWAY, NJ, USA, 15 February 2009 (2009-02-15), pages 1406-1409, XP031445928, ISBN: 978-89-5519-138-7 * page 1406, left-hand column, line 14 - page 1409, left-hand column, line 18; figures 1-7 * | 1-15 | |
| | -/-- | | TECHNICAL FIELDS SEARCHED (IPC) H03F H01L |

The present search report has been drawn up for all claims

| Place of search | Date of completion of the search | Examiner |
|---|---|---|
| The Hague | 28 February 2023 | Fedi, Giulio |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

                                             
& : member of the same patent family, corresponding document

EPO FORM 1503 03.82 (P04C01)

Europäisches
Patentamt

European
Patent Office

Office européen
des brevets

# EUROPEAN SEARCH REPORT

Application Number

EP 22 30 6454

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | Vaishya Rashmi ET AL: "An Overview of Constant-k Type Filters", International Journal of Recent Research in Electrical and Electronics Engineering, 3 April 2017 (2017-04-03), pages 99-104, XP093027364, Retrieved from the Internet: URL:https://www.paperpublications.org/upload/book/An%20Overview%20of%20Constant-k%20Type%20Filters-968.pdf [retrieved on 2023-02-28] * page 101, line 7 - page 102, line 1; figures 5,6 * | 1-15 | |

TECHNICAL FIELDS
SEARCHED       (IPC)

The present search report has been drawn up for all claims

| Place of search | Date of completion of the search | Examiner |
|---|---|---|
| The Hague | 28 February 2023 | Fedi, Giulio |

EPO FORM 1503 03.82 (P04C01)